Europäisches Patentamt

European Patent Office

Office européen des brevets

(19)

(11) Numéro de publication : **0 130 112**
**B1**

(12) # FASCICULE DE BREVET EUROPÉEN

(45) Date de publication du fascicule du brevet :
30.09.87

(51) Int. Cl.⁴ : **H 03 B 23/00**

(21) Numéro de dépôt : **84401249.2**

(22) Date de dépôt : **18.06.84**

(54) **Dispositif de génération d'un signal modulé en fréquence.**

(30) Priorité : 28.06.83 FR 8310676

(43) Date de publication de la demande :
02.01.85 Bulletin 85/01

(45) Mention de la délivrance du brevet :
30.09.87 Bulletin 87/40

(84) Etats contractants désignés :
DE GB IT NL SE

(56) Documents cités :
EP-A- 0 088 669
FR-A- 2 281 001
US-A- 2 774 872
US-A- 3 364 437
US-A- 3 621 403

(73) Titulaire : THOMSON-CSF
173, Boulevard Haussmann
F-75379 Paris Cédex 08 (FR)

(72) Inventeur : Tabourier, Rémy
THOMPSON-CSF SCPI 173, bld Haussmann
F-75379 Paris Cedex 08 (FR)
Inventeur : Quintric, Jean-Michel
THOMPSON-CSF SCPI 173, bld Haussmann
F-75379 Paris Cedex 08 (FR)

(74) Mandataire : Benoit, Monique et al
THOMSON-CSF SCPI 19, avenue de Messine
F-75008 Paris (FR)

EP 0 130 112 B1

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

Jouve, 18, rue St-Denis, 75001 Paris, France

**Description**

La présente invention concerne un dispositif de génération d'un signal modulé en fréquence.

Certains systèmes tels que les altimètres ou les radars à compression d'impulsion émettent un signal modulé en fréquence selon une loi de modulation fixée a priori. Les oscillateurs pilotes qui les équipent doivent suivre cette loi avec les plus grandes précision et stabilité possibles.

On connaît plusieurs procédés d'obtention d'un signal de durée limitée modulé en fréquence :

en modulant directement un oscillateur à fréquence commandée par une tension, dit oscillateur V.C.O., et en complétant éventuellement par une chaîne de contre-réaction ;

en commandant mécaniquement un élément d'oscillateur, en général une armature de condensateur ;

en utilisant une ligne dispersive de caractéristique prédéterminée, alimentée par une impulsion brève, ce qui permet d'obtenir un signal de durée limitée ;

dans le cas d'une modulation linéaire, en combinant une boucle de phase et une ligne à retard dont le retard de groupe est connu, un tel procédé étant décrit dans l'article de W. J. Caputi, « Stabilized linear FM generator » paru dans IEEE trans. on A.E.S., Septembre 1973.

La mise en œuvre des procédés décrits ci-dessus impose l'utilisation de composants analogiques de haute qualité et de mise en œuvre délicate si l'on désire une bonne stabilité en température et dans le temps.

D'autre part, le brevet US-A-3 621 403 décrit un dispositif de génération d'un signal modulé en fréquence selon une loi prédéterminée comportant une horloge et un générateur numérique délivrant un signal de sortie dont chaque alternance présente une durée variable, multiple de la période d'horloge.

De plus, le brevet EP-A-0 088 669 publié le 14.9.83 après la date de priorité du présent brevet et donc n'étant pris en compte dans l'état de la technique qu'en vertu de l'article 54(3) de la CBE, décrit un dispositif de génération d'un signal modulé en fréquence selon une loi prédéterminée comprenant une horloge, un générateur numérique délivrant d'une part un signal de sortie dont chaque alternance présente une durée variable, multiple de la période d'horloge, et d'autre part un signal d'erreur ainsi que des moyens de correction d'erreur.

La présente invention a pour objet un dispositif de précision générant un signal modulé en fréquence selon une loi prédéterminée ; il est constitué par un générateur entièrement numérique, fournissant un signal modulé en fréquence suivant une loi proche de la loi de modulation théorique désirée. Le signal délivré par ce générateur comporte donc des erreurs systématiques inhérentes à son principe. C'est pourquoi il délivre parallèlement un signal représentant les erreurs de modulation dudit signal par rapport à la loi de modulation prédéterminée.

Selon l'invention, le dispositif de génération d'un signal modulé en fréquence selon une loi prédéterminée, comporte un générateur numérique qui, à partir d'un signal d'horloge de période $T = 1/f_H$ et d'un signal de commande extérieur ($S_d$), délivre d'une part un signal de sortie [s(t)] dont chaque alternance présente une durée variable ($N_0T$, $N_1T$, ..., $N_kT$, ..., $N_nT$), qui est un multiple entier de la période d'horloge, le dispositif étant caractérisé en ce que ledit générateur délivre d'autre part :

un signal d'erreur ($S_e$) représentant les erreurs dudit signal de sortie [s(t)] par rapport à un signal théorique ($S_t$) modulé selon la loi prédéterminée ; et en ce que ledit dispositif comprend en série :

des moyens de correction d'erreur alimentés par ledit signal de sortie [s(t)] et commandés par le signal d'erreur (Se), lesdits moyens de correction d'erreurs comprennent un circuit à retard qui, commandé par ledit signal d'erreur ($S_e$), applique un retard variable audit signal de sortie S(t) et comprennent en outre connectés en série, en sortie du circuit à retard ;

un détecteur amplitude/phase alimenté sur une première entrée par ledit signal de sortie retardé ;

un amplificateur ; et

un circuit oscillateur commandé en fréquence dont la sortie est appliquée sur la deuxième entrée dudit détecteur amplitude/phase.

Le dispositif, objet de la présente invention, permet de remédier aux inconvénients des procédés de l'art antérieur mentionnés ci-dessus.

Le dispositif selon l'invention ne nécessite aucun réglage et permet de générer avec une très grande précision toute forme de modulation de fréquence. Il présente également l'avantage d'être simple, peu coûteux, fiable et insensible à la température et au vieillissement.

La présente invention sera mieux comprise à la lecture de la description détaillée faite ci-après avec référence aux figures ci-annexées qui représentent :

Figure 1   le schéma synoptique du dispositif numérique selon l'invention ;

Figure 2   un mode de réalisation d'un générateur numérique ;

Figures 3A et 3B   deux modes de réalisation détaillés d'une partie du générateur numérique de la figure 2 ;

Figure 4   la représentation de l'erreur de phase entre le signal réel en sortie du générateur numérique de la figure 2 et le signal théorique ;

Figure 5A   un mode de réalisation détaillé d'un sous-ensemble d'un dispositif pour la correction en temps des erreurs du signal ;

Figure 5B   un mode de réalisation détaillé d'un sous-ensemble du dispositif selon l'invention ;

Figures 6A, 6B et 6C   trois modes de réalisation détaillés d'un circuit du sous-ensemble représenté par la figure 5A ou 5B ;

Figure 7 un autre mode de réalisation détaillé du deuxième sous-ensemble du dispositif selon l'invention pour la correction en phase des erreurs ;

Figure 8 un mode de réalisation détaillé d'un autre circuit du deuxième sous-ensemble représenté par la figure 5A, 5B ou 7.

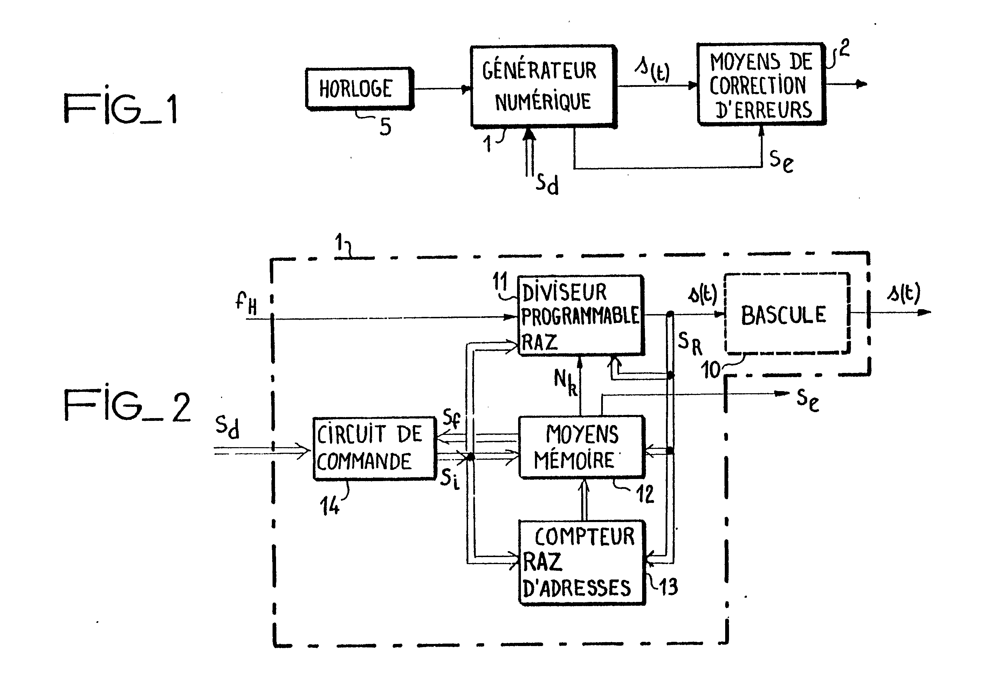

La figure 1 représente le schéma synoptique du dispositif numérique selon l'invention pour la génération d'un signal modulé en fréquence selon une loi de modulation connue a priori et représentée par le signal $S_T$ dans la figure 4.

Un générateur entièrement numérique 1 (dont un mode de réalisation préférentiel est illustré par la figure 2) génère un signal modulé en fréquence à partir d'un signal d'horloge $f_H$ fourni par une horloge 5. Le début de la séquence, répétitive ou non, est éventuellement commandé par un signal extérieur Sd.

Le signal modulé s(t) généré par le générateur numérique 1 présente, par rapport à un signal théorique $S_t$ que l'on aurait dû obtenir avec une modulation reproduisant très exactement la loi de modulation connue a priori, des erreurs de phase représentées par un signal $S_e$ délivré par le générateur numérique 1.

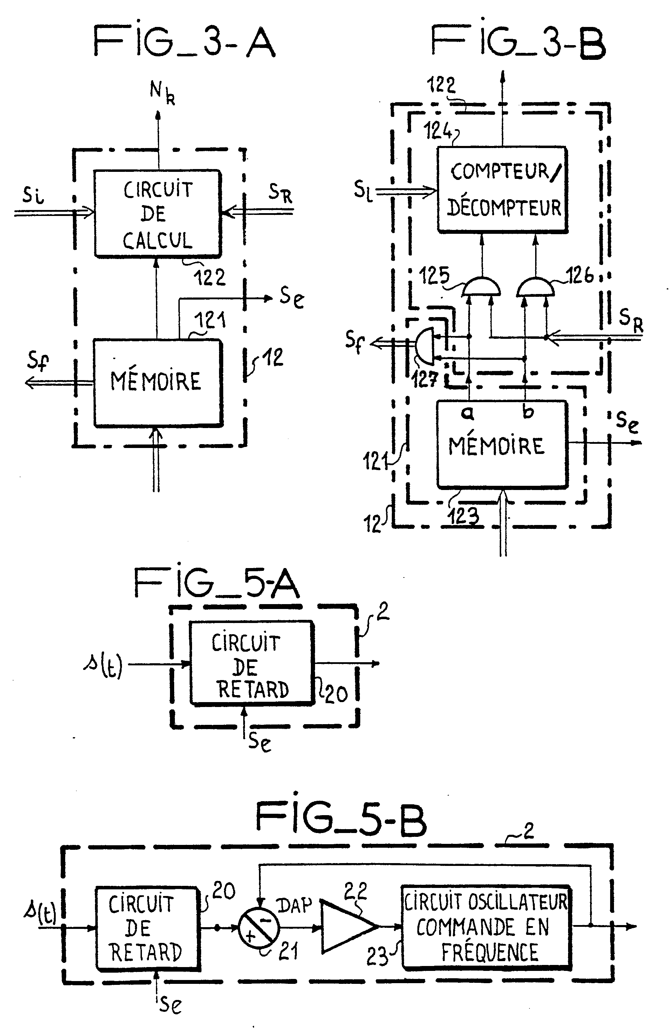

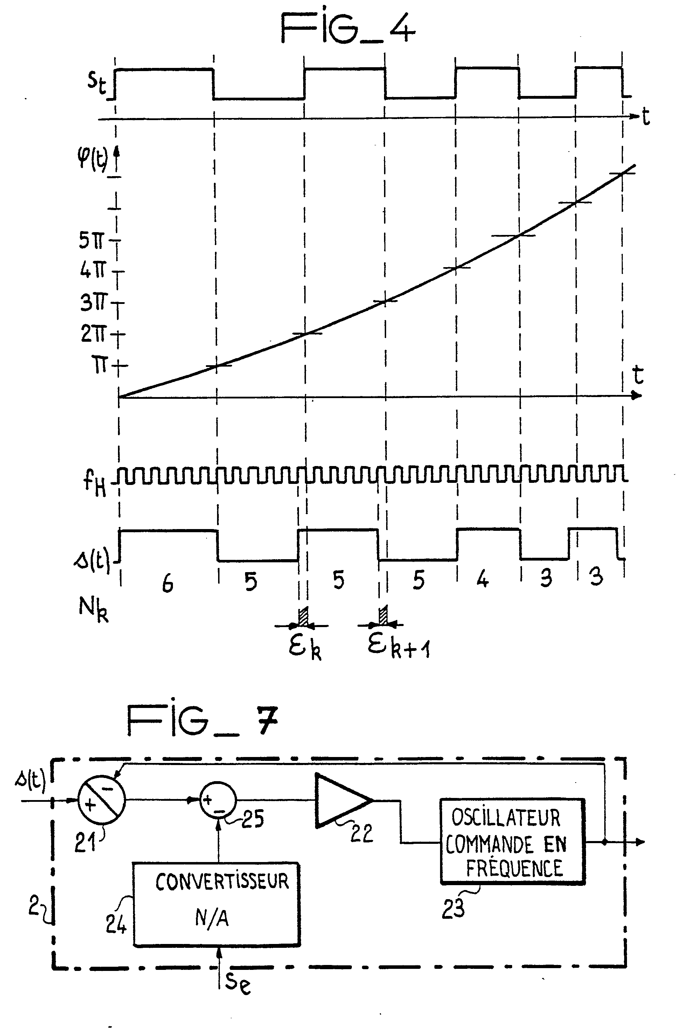

La sortie du générateur numérique 1 est raccordée à la première entrée de moyens 2 de correction d'erreurs (deux exemples de réalisation de ce circuit 2 sont illustrés par les figures 5A, 5B et 7), dont la deuxième entrée reçoit le signal d'erreur $S_e$, généré par le générateur numérique 1.

La figure 2 représente le circuit 1 générant numériquement le signal modulé en fréquence selon une loi très proche de la loi théorique fixée a priori.

Le signal est obtenu par division, dans un diviseur programmable 11, de la fréquence $f_H$ de l'horloge 5. Le diviseur 11 délivre un signal s(t) dont chaque cycle présente une durée variable $N_0T$, $N_1T$, ..., $N_kT$, ..., $N_nT$ avec $N_k$ (k = 0, ..., n) un nombre entier naturel quelconque fourni par des moyens mémoire 12 et

$$T = 1/f_H,$$

la période du signal d'horloge. Selon un mode de réalisation préférentiel, le diviseur programmable 11 est un décompteur dont le fonctionnement est décrit plus loin.

Une bascule bistable 10 peut être éventuellement connectée en sortie du diviseur programmable 11 afin de générer un signal s(t) dont le facteur de forme est proche de 1/2.

Le signal impulsionnel $S_R$ prélevé sur la sortie s(t) du diviseur 11 commande les moyens mémoire 12, un compteur d'adresses 13 et le diviseur programmable 11 lui-même.

Les (n + 1) nombres $N_k$ (k = 0 à n) permettant une première approche du signal théorique modulé sont fournis au diviseur programmable 11 par les moyens mémoire 12.

Le compteur d'adresses 13 commande l'émission des rangs successifs de division $N_k$ (k = 0, ..., n) par les moyens mémoire 12 vers le diviseur programmable 11. La réinitialisation du compteur d'adresses 13, du diviseur programmable 11 et des moyens mémoire 12 est assurée par un signal Si appliqué sur leur entrée RAZ et émis par un circuit de commande 14 qui peut être de façon préférentielle une bascule R/S ; celui-ci est alimenté par le signal extérieur $S_d$ de début de séquence et par un signal $S_f$ de fin de séquence, délivré par les moyens mémoire 12 en fin d'émission des (n + 1) rangs de division $N_k$ (k = 0, ..., n). Il est possible de produire le signal $S_d$ à partir du signal $S_f$ ce qui réalise un générateur périodique.

Si le diviseur 11 est un décompteur programmable comme dans le mode de réalisation préférentiel de l'invention, il reçoit des moyens mémoire 12 une valeur $N_R$ et est chargé à l'instant $t_k$, par une valeur $N_k - 1$. Chaque impulsion d'horloge diminue son contenu d'une unité. Quand le décompteur affiche la valeur « 0 », il délivre une impulsion et reçoit pour le cycle suivant la valeur $N_{k+1}$ des moyens mémoire 12. Il affiche la valeur $N_{k+1} - 1$ et comme précédemment est décrémenté d'une unité à chaque pas d'horloge. Il délivre une impulsion lorsqu'il atteint la valeur « 0 ». Il est alors chargé par la valeur $N_{k+2} - 1$ et ainsi de suite jusqu'à ce que la série des rangs $N_k$ soit épuisée et la séquence désirée terminée.

Selon un autre mode de réalisation, le circuit diviseur programmable 11 peut être un compteur qui, après avoir été chargé par une valeur $N_M + 1 - N_k$, $N_M$ étant la valeur maximum que peut afficher le compteur et $N_k$ le rang de la division fourni par les moyens mémoire 12, effectue à partir de cette valeur une incrémentation d'une unité à chaque cycle d'horloge jusqu'à atteindre la valeur $N_M$. En même temps que le compteur programmable affiche la valeur $N_M$, il délivre une impulsion qui commande également l'émission par les moyens mémoire 12 du rang de division $N_{k+1}$ suivant et le chargement de la valeur $N_M + 1 - N_{k+1}$ dans le compteur et ainsi de suite.

En plus des rangs de division $N_k$, les moyens mémoire 12 délivrent un signal numérique $S_e$ qui représente les différences entre le signal impulsionnel s(t) de période variable généré de façon numérique par le diviseur 11 et le signal théorique modulé en fréquence qu'on aurait dû obtenir et qui par conséquent est constitué par l'ensemble des erreurs engendrées par une telle génération. Ces erreurs sont déterministes comme il est expliqué ci-après lors du fonctionnement du dispositif de la figure 1.

Dans les figures 5A et 5B représentant deux modes de réalisation des moyens 2 de correction d'erreurs les erreurs déterministes du signal engendré par le générateur numérique 1 sont corrigées directement en temps. Le signal numérique $S_e$ délivré par les moyens mémoire 12 (Fig. 2) est un signal d'erreur de temps. Dans le cas de la figure 7, les erreurs sont corrigées en phase.

Dans le cas de la figure 7, les moyens 2 de correction d'erreurs comprennent en série un détecteur amplitude/phase 21, alimenté sur une première entrée par le signal engendré par le générateur numérique 1 (signal s(t)), un circuit additionneur 25, un amplificateur 22 et un circuit oscillateur commandé en fréquence 23. Le signal de sortie du détecteur 21 est appliqué sur l'entrée positive de l'additionneur 25 dont l'entrée négative reçoit le signal d'erreur $S_e$ converti en un signal analogique par un convertisseur numérique/analogique 24. La sortie du circuit oscillateur 23 est rebouclée sur la deuxième entrée du détecteur 21.

Dans la figure 5A le signal d'erreur Se commande un circuit de retard 20 dont l'entrée reçoit le signal s(t) engendré par le générateur numérique 1 et qui délivre le signal retardé, donc corrigé.

Selon le mode de réalisation de la figure 5B, l'approche de la loi de modulation désirée peut être encore améliorée en appliquant ledit signal retardé, délivré par le circuit de retard 20, à l'entrée d'une boucle de phase qui comprend en série un détecteur amplitude/phase 21, un amplificateur 22, et un circuit oscillateur commandé en fréquence 23. La sortie du circuit oscillateur 23 est rebouclée sur la deuxième entrée du détecteur amplitude/phase 21.

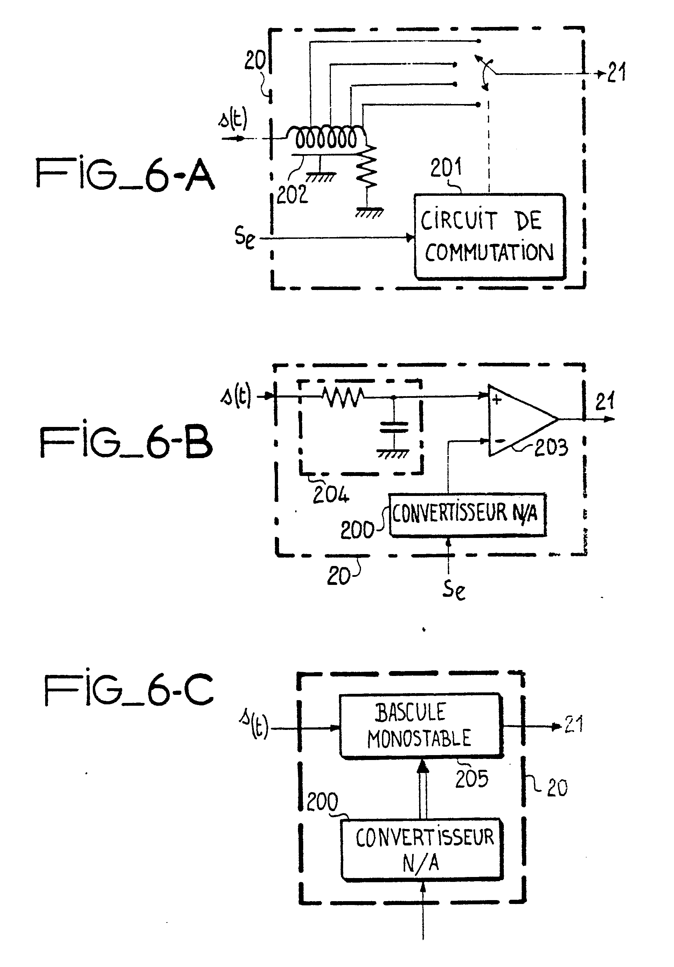

Le retard appliqué par le circuit 20 et commandé par le signal d'erreur $S_e$ peut être obtenu de différentes façons, comme illustré par exemple par les figures 6A, 6B et 6C.

La figure 6A représente un circuit de retard constitué par une ligne à retard 202 à sorties multiples qui correspondent chacune à un retard et qui sont sélectionnées par le signal d'erreur $S_e$ par l'intermédiaire d'un circuit de commande 201.

Les figures 6B et 6C représentent deux modes de réalisation, non limitatifs et connus de l'homme de l'art d'un circuit à retard à variations continues, commandé par une tension fournie par la conversion du signal numérique d'erreur $S_e$, par l'intermédiaire d'un circuit convertisseur numérique/analogique 200.

Dans la figure 6B, le circuit à retard est un comparateur 203 à seuil variable déterminé par le circuit convertisseur 200. Le circuit à retard 203 est alimenté par le signal de sortie s(t) du générateur 1, préalablement filtré dans un filtre 204 formé d'une résistance et d'un condensateur.

Dans la figure 6C, le circuit à retard est une bascule monostable 205 classique dont le retard variable est commandé par le circuit convertisseur 200.

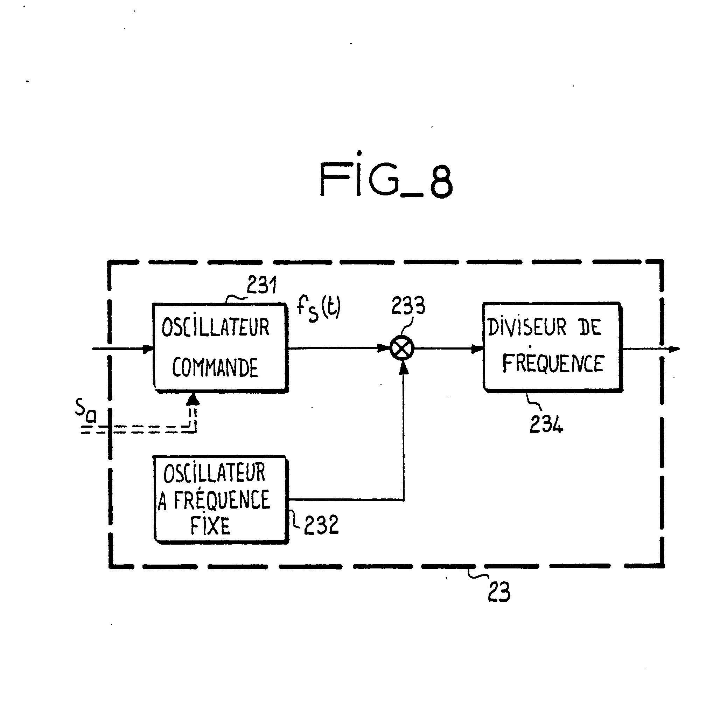

Dans le cas de la figure 5A selon le mode de réalisation de la figure 6A, 6B ou 6C, le circuit de retard 20 comprend de façon préférentielle un retard systématique constant, permettant d'appliquer des corrections négatives. La boucle de phase 21, 22, 23 telle que représentée sur la figure 5B n'a alors pour rôle que d'effectuer des transpositions si nécessaire. En effet, le générateur numérique 1, auquel est associé un circuit de retard 20, est indépendant et n'est plus sensible aux caractéristiques du détecteur amplitude/phase 21 ; les réglages des divers éléments de l'ensemble générateur numérique 1-circuit de retard 20 sont indépendants. Le circuit oscillateur commandé 23 peut être un simple oscillateur commandé en fréquence mais peut être réalisé comme illustré par la figure 8.

Il comprend un oscillateur 231 commandé en fréquence par le signal amplifié en sortie du circuit 22 des figures 5B et 7, complété éventuellement par un signal $S_a$ d'anticipation représentatif de la loi de modulation désirée, fixée a priori. Le signal de sortie de l'oscillateur commandé 231 et le signal à fréquence fixe délivré par un oscillateur 232 sont appliqués à l'entrée d'un mélangeur 233, dont la sortie alimente un diviseur de fréquence 234.

Si l'on suppose que la fréquence du signal s(t) engendré par le générateur numérique 1 de la figure 1 est désignée par $f_e(t)$, la fréquence $f_s(t)$ du signal de sortie de l'oscillateur commandé 231 est donnée par :

$$f_s(t) = L \cdot f_e(t) \pm f_o,$$

formule dans laquelle $f_o$ est la fréquence fixe de l'oscillateur 232 et L le rang de la division de fréquence réalisée dans le diviseur 234.

Le cas $L = 1$ et $f_o = 0$ correspond au cas où le circuit 23 ne comprend que l'oscillateur commandé 231.

Le principe de fonctionnement du dispositif numérique selon l'invention, illustré par la figure 1 est le suivant, en se référant également aux figures 2 et 7.

Un signal modulé en fréquence ou en phase peut s'écrire $y = A \cdot \sin[\varphi(t)]$ où $d\varphi/dt$ n'est pas constant et varie selon une loi prédéterminée. Les intervalles $\Delta t_k = t_{k+1} - t_k$ entre les instants successifs $t_{k+1}$ et $t_k$ pour lesquels $\varphi(t)$ est un multiple entier de $2\pi$ ne sont donc pas constants. Pour engendrer numériquement dans le générateur 1 un signal dont la modulation de fréquence suit le plus près possible une loi de modulation fixée a priori, et cela à partir de la fréquence d'horloge $f_H$, fixe et choisie assez élevée, on cherche à obtenir une approximation de chaque intervalle $\Delta t_k$ par un nombre entier $N_k$ de périodes $T = 1/f_H$ d'horloge. On peut prendre pour $N_k$ l'entier le plus proche de $\Delta t_k/T$ mais il est préférable de prendre $N_k = M_{k+1} - M_k$ où $M_{k+1}$ et $M_k$ sont les entiers les plus proches de $t_{k+1}/T$ et $t_k/T$ respectivement. La précision sera meilleure. Le principe du générateur numérique 1 sera expliqué plus en détail ci-après en référence aux figures 2, 3A, 3B et 4.

Le générateur numérique 1 génère donc un signal impulsionnel s(t) dont la fréquence varie à chaque période mais reste égale au quotient de la fréquence d'horloge $f_H$ par un nombre entier $N_k$, variable d'une période à l'autre selon une séquence prédéterminée, répétitive ou non, afin que la modulation de fréquence obtenue soit la plus proche possible de la loi de modulation fixée a priori.

En règle générale, pour la loi de modulation souhaitée, il résulte des erreurs de phase sur le signal engendré par le générateur numérique 1.

Dans le cas d'un signal module linéairement en fréquence, on peut mettre ces erreurs en évidence en mélangeant le signal délivré par le générateur numérique 1 et ce même signal retardé. En sortie du mélangeur, un filtre passe-bas ne laisse passer que les signaux dont la fréquence est la différence des fréquences sur les deux entrées. La fréquence du signal de sortie est constante et une analyse spectrale du signal obtenu permet de mettre en évidence le bruit de phase qui accompagne la raie utile.

Dans le cas d'un signal à modulation de fréquence quelconque, le signal délivré ne peut pas être filtré par un circuit passif.

Un procédé connu consiste à utiliser un oscillateur commandé en fréquence dans une boucle de phase dont la bande passante est assez étroite pour rejeter les erreurs à une fréquence éloignée de la fréquence instantanée du signal utile.

Les erreurs dues aux différences qui existent entre $t_k/T$ et $M_k$, l'entier le plus proche, ont des effets analogues à ceux d'un bruit mais sont parfaitement déterministes : en effet les nombres $t_k/T$ sont parfaitement connus ainsi que les nombres $\varepsilon_k = t_k/T - M_k$ qui sont compris entre $-0,5$ et $+0,5$.

Dans le fonctionnement interne de la boucle de phase 21, 22, 23, le signal d'erreur est $S_e - S\delta$, où $S_e$ et $S\delta$ sont respectivement les signaux d'erreur de phase du générateur numérique 1 et du circuit oscillateur commandé 23. Le signal d'erreur $S_e - S\delta$ modifié par le filtre de boucle vient moduler le circuit l'oscillateur commandé 23 en produisant ainsi les erreurs $S\delta$. Le fonctionnement est en boucle fermée : les composantes haute fréquence de $S_e$ ne sont donc pas dans le signal d'erreur $S\delta$, la boucle 21, 22, 23 ayant une bande passante limitée.

En se référant encore à la figure 7, le cas $S\delta = 0$ correspond à un fonctionnement idéal où le circuit oscillateur commandé 23 présente exactement la modulation de fréquence souhaitée. L'erreur de boucle est celle du générateur numérique 1. Or celle-ci est prévisible par le calcul lors de la détermination des $N_k$. Il suffit alors de stocker également dans les moyens mémoire 12 (Figure 2) les quantités $\varepsilon_k = t_k/T - M_k$ sous forme numérique, ce qui impose un accroissement de sa capacité. Chaque valeur $\varepsilon_k$ lue peut être alors par exemple convertie sous forme analogique conformément au mode de réalisation de la figure 7. L'ensemble des valeurs $\varepsilon_k$ est désigné par $S_e$, signal numérique d'erreur. Le signal d'erreur $S_e$ est soustrait du signal d'erreur de la boucle de phase en aval de la détection amplitude/phase dans le circuit de détection amplitude/phase. Dans le cas idéal, cette différence est nulle et ne module pas le circuit oscillateur commandé 23, ce qui justifie a posteriori l'hypothèse $S\delta = 0$.

Dans la pratique, $S\delta$ n'est pas rigoureusement nul et comporte entre autres l'erreur nécessaire pour faire fonctionner la boucle de phase dès que le signal d'anticipation $S_a$ est absent ou imparfait.

Le seul réglage nécessité dans ce cas est celui de l'égalité des gradients de sortie (en volts/radian) du détecteur de phase 21 et du convertisseur numérique/analogique 24.

Le principe du générateur numérique 1 a été mentionné dans ses grandes lignes dans ce qui précède. Il faut rappeler qu'il génère un signal dont la fréquence varie d'un cycle à l'autre, la fréquence restant égale pour chaque période d'ordre k (entre deux instants $t_k$ et $t_{k+1}$) au quotient de la fréquence d'horloge $f_H$ par un nombre entrée $N_k$, variable d'une période à l'autre selon une séquence prédéterminée. La modulation de fréquence obtenue doit être le plus proche possible, avec la condition ci-dessus, de la loi de modulation théorique désirée.

Pour avoir une précision correcte, les valeurs des nombres $N_k$ sont assez élevées, de l'ordre de cent par exemple grâce à un choix approprié de la fréquence d'horloge. Elles nécessitent donc dans ce cas un grand nombre d'éléments binaires (bits) de codage dans les moyens mémoire 12.

Pour de nombreuses applications, les valeurs successives $N_k$ (k = 0, ..., n) diffèrent au plus d'une unité, par exemple :

$$N_k - N_{k-1} = \Delta N_k$$

avec $\Delta N_k \in \{-1, 0, 1\}$. On a donc tout intérêt à calculer chaque valeur $N_k$ à partir de la valeur précédente $N_k = N_{k-1} + \Delta N_k$ où seules la valeur initiale $N_0$ et les valeurs successives de $\Delta N_k$ sont mises en mémoire dans les moyens 12. Deux éléments binaires suffisent pour mettre en mémoire les variations $\Delta N_k$ par exemple

| | |
|---|---|
| 00 | $N_k = 0$ |
| 01 | $N_k = 1$ |
| 10 | $N_k = -1$ |
| 11 | fin de la séquence $= S_f$ |

Cette technique peut être étendue à un codage sur trois éléments binaires permettant de coder des variations $\Delta N_k$ choisies parmi les valeurs suivantes :

$$N_k \in \{-3, -2, -1, 0, 1, 2, 3\}$$

et le signal $S_f$ de fin de séquence, ou sur un plus grand nombre d'éléments binaires.

Les figures 3A et 3B illustrent deux modes de réalisation préférentiels des moyens mémoire 12, correspondent respectivement au cas général d'un codage des variations $\Delta N_k$ et au cas plus particulier où les variations $|\Delta N_k|$ sont au plus égales à 1.

Dans la figure 3A, les moyens mémoire 12 comprennent un circuit mémoire morte 121 (ou ROM), contenant les différentes variations $\Delta N_k$ (k = 0, ..., n) existant entre deux rangs successifs de division $(N_{k-1}, N_k)$. Ce circuit mémoire 121 délivre successivement les variations $\Delta N_0, ..., \Delta N_k, ..., \Delta N_n$ au rythme imposé par le compteur d'adresses 13. Un circuit de calcul 122 initialisé à la valeur $N_0$ par le signal $S_i$ délivré par le circuit de commande 14 reçoit les valeurs fournies par le circuit mémoire 121 et effectue successivement les sommes :

$$N_0 = N'_0 + \Delta N_0$$
$$N_1 = N_0 + \Delta N_1$$
$$N_2 = N_1 + \Delta N_2$$
$$\vdots$$
$$N_k = N_{k-1} + \Delta N_k$$
$$\vdots$$
$$N_n = N_{n-1} + \Delta N_n$$

correspondant aux rangs successifs des divisions de fréquence qui alimentent le diviseur programmable 11 au rythme donné par le signal impulsionnel $S_R$.

Le circuit mémoire 121 fournit avec l'émission de la valeur $N_n$ (11 comme dans l'exemple ci-dessous) le signal $S_f$ de fin de séquence quand toutes les valeurs $\Delta N_k$ (k = 0 à n) ont été lues.

Dans la figure 3B, les variations $|\Delta N_k|$ sont au plus égales à 1. Deux éléments binaires a et b suffisent. Le circuit mémoire 121 comprend une mémoire morte 123, émettant les deux éléments binaires a et b, et une porte ET 127 qui délivre le signal $S_f$ de fin de séquence lorsque les éléments binaires a et b sont égaux simultanément à 1 (comme indiqué dans l'exemple ci-dessus).

Le circuit de calcul 122 comprend dans ce cas un compteur-décompteur 124 et deux portes ET 125 et 126, qui reçoivent chacune sur une première entrée le signal impulsionnel $S_R$ (en sortie du diviseur programmable 11) et sur une deuxième entrée les éléments binaires a et b respectivement et qui commandent, selon le signal impulsionnel $S_R$, l'application des éléments binaires a et b à l'entrée du compteur-décompteur 124. Ce compteur-décompteur 124 est initialisé à $N'_0$ par le signal $S_i$ délivré par le circuit de commande 14 la valeur qu'il affiche est incrémentée ou décrémentée jusqu'à la valeur $N_k$ suivant les éléments binaires a, b appliqués à son entrée et tels que définis par exemple plus haut, c'est-à-dire :

| a | b | $\Delta N_k$ |
|---|---|---|
| 0 | 0 | 0 |
| 0 | 1 | 1 |
| 1 | 0 | — 1 |

Cette valeur $N_k$ est alors émise vers le diviseur programmable 11.

Ainsi qu'on l'a mentionné plus haut, les instants $t_k$ sont ceux auxquels la phase $\varphi(t)$ est un multiple entier k de $2\pi$ : $\varphi(t_k) = k \cdot 2\pi$.

Mais on peut également utiliser, pour les instants $t_k$, ceux pour lesquels $\varphi(t_k)$ est un multiple entier de $\pi$. Les moyens mémoire 12 contiennent alors un nombre double d'informations $N_k$ ou $\Delta N_k$. Une simple bascule bistable 10 (Fig. 2) alimentée par les impulsions de sortie s(t) du diviseur programmable 11 délivre alors un signal sensiblement carré dont les fronts montants correspondent à

$$\varphi(t) = k \cdot 2\pi$$

et les fronts descendants à $\varphi(t) = (2k + 1) \cdot \pi$. C'est ce qui est représenté par la figure 4 qui illustre la courbe de phase $\varphi(t)$, le signal théorique modulé désiré $S_t$, le signal d'horloge de fréquence $f_H$, et le signal s(t) délivré par le générateur numérique 1.

Sur la représentation du signal obtenu s(t) ont été portés les nombres $N_k$ et les erreurs $\varepsilon_k$ déterministes formant le signal d'erreur $S_e$.

On a ainsi réalisé un dispositif permettant de reproduire une loi de modulation de fréquence quelconque, répétitive ou non, avec une excellente pureté spectrale.

La présente invention s'applique entre autres aux radars ou auto-directeurs à compression d'impulsion, altimètres, télémètres, analyseurs de spectre. Le contenu de la mémoire pouvant être relu indéfiniment dans les deux sens, la présente invention est applicable aux radars Doppler continus ou non pour la mesure de distance.

## Revendications

1. Dispositif de génération d'un signal modulé en fréquence selon une loi prédéterminée, comportant un générateur numérique qui, à partir d'un signal d'horloge de période T = 1/$f_H$ et d'un signal de commande extérieur ($S_d$), délivre d'une part un signal de sortie [s(t)] dont chaque alternance présente une durée variable ($N_0T$, $N_1T$, ..., $N_KT$, ..., $N_nT$), qui est un multiple entier de la période d'horloge, caractérisé en ce que ledit générateur délivre d'autre part ; un signal d'erreur ($S_e$) représentant les erreurs dudit signal de sortie [s(t)] par rapport à un signal théorique ($S_t$) modulé selon la loi prédéterminée ; et en ce que ledit dispositif comprend en série :

des moyens (2) de correction d'erreur alimentés par ledit signal de sortie [s(t)] et commandés par le signal d'erreur (Se), lesdits moyens (2) de correction d'erreurs comprennent un circuit à retard (20) qui, commandé par ledit signal d'erreur ($S_e$), applique un retard variable audit signal de sortie s(t) et comprennent en outre connectés en série, en sortie du circuit à retard (20)

un détecteur amplitude/phase (21) alimenté sur une première entrée par ledit signal de sortie retardé ;

un amplificateur (22) ; et

un circuit oscillateur commandé en fréquence (23) dont la sortie est appliquée sur la deuxième entrée dudit détecteur amplitude/phase (21).

2. Dispositif selon la revendication 1, caractérisé en ce que le circuit à retard (20) est une ligne à retard 202 à sorties multiples sélectionnées par un circuit de commutation (201).

3. Dispositif selon la revendication 1 ou 2, caractérisé en ce que le circuit à retard (20) est à variation continue commandée par le signal d'erreur ($S_e$) par l'intermédiaire d'un convertisseur numérique/analogique (200).

4. Dispositif selon la revendication 3, caractérisé en ce que le circuit à retard (20) comprend un comparateur (203) à seuil variable, alimenté par le signal de sortie (s(t)), retardé ou non, filtré par un circuit de filtrage (204).

5. Dispositif selon la revendication 3, caractérisé en ce que le circuit à retard (20) comprend une balance monostable (205) à retard variable.

6. Disposition selon la revendication 1, caractérisé en ce que les moyens (2) de correction d'erreurs comprennent en série :

un détecteur amplitude/phase (21) alimenté sur une première entrée par le signal [s(t)] délivré par le générateur numérique (1) ;

un circuit additionneur (25) recevant sur une entrée positive le signal de sortie du détecteur amplitude/phase (21) et sur une entrée négative le signal d'erreur (Se) par l'intermédiaire d'un convertisseur numérique/analogique (24) ;

un circuit oscillateur (23) commandé en fréquence par le signal de sortie du circuit additionneur (25), par l'intermédiaire d'un amplificateur (22) ; la sortie du circuit oscillateur (23) étant appliquée sur la deuxième entrée du détecteur amplitude/phase (21).

7. Dispositif selon l'une quelconque des revendications 1 à 6, caractérisé en ce que le circuit oscillateur (23) comprend :

un premier oscillateur (231) commandé en fréquence par le signal (s(t)) délivré par le générateur numérique (1) ;

un mélangeur (233) recevant sur une première entrée le signal de fréquence variable délivré par ledit premier oscillateur (231) et sur une deuxième entrée un signal à fréquence fixe délivré par un deuxième oscillateur (232) ; et

un circuit (234) diviseur de fréquence, qui reçoit le signal de sortie dudit mélangeur (233) et dont la sortie est appliquée sur la deuxième entrée du détecteur amplitude/phase (21).

8. Dispositif selon l'une quelconque des revendications 1 à 7, caractérisé en ce que ledit circuit oscillateur (23) reçoit un signal ($S_a$) d'anticipation, représentant la loi théorique de modulation de fréquence à générer.

9. Dispositif selon l'une quelconque des revendications 1 à 8, caractérisé en ce que le générateur numérique (1) comprend :

un diviseur programmable (11) générant un signal (s(t)) dont chaque période d'ordre k est un multiple entier $N_K$ supérieur à 1, k variant de 0 à n, de la période T du signal d'horloge, et est le plus proche possible de la période correspondante du signal théorique ($S_t$) ;

des moyens mémoire (12) fournissant (n + 1) nombres naturels ($N_0$, ..., $N_K$, ... $N_n$) successivement au diviseur programmable (11), et ledit signal d'erreur ($S_e$) ;

des moyens d'adressage (13) pour la commande des moyens mémoire (12), et

des moyens de commande (14) pour le déclenchement dudit dispositif et son arrêt en fin de lecture du contenu des moyens mémoire (12), et la réinitialisation du diviseur programmable (11) et des moyens d'adressage (13) ; le diviseur programmable (11), les moyens mémoire (12) et les moyens d'adressage (13) étant également commandés par un signal ($S_R$) prélevé en sortie dudit diviseur programmable (11).

10. Dispositif selon la revendication 9, caractérisé en ce que le diviseur programmable (11) est un décompteur dont le contenu subit, à chaque cycle d'horloge, une décrémentation d'une unité depuis la valeur $N_k$ — 1, le nombre naturel $N_k$ étant fourni par les moyens mémoire (12) au début de chaque cycle de comptage, jusqu'à la valeur 0 marquant la fin du cycle de comptage d'ordre k et correspondant à l'émission par le décompteur d'une impulsion qui coïncide avec le Nième et dernier cycle d'horloge du k-ième cycle de comptage, cette impulsion provoquant le chargement dans le décompteur de la valeur $N_{k+1}$ — 1, les nombres naturels $N_k$ avec k compris entre 0 et n, étant successivement fournis par les moyens mémoire (12) adressés par les moyens d'adressage (13).

11. Dispositif selon la revendication 9, caractérisé en ce que le diviseur programmable (11) est un compteur dont le contenu subit à chaque cycle d'horloge une incrémentation d'une unité depuis la valeur $N_{M+1}$ — $N_k$ jusqu'à la valeur $N_M$ marquant la fin du cycle de comptage d'ordre k et correspondant à l'émission par le compteur d'une impulsion qui coïncide avec le Nième et dernier cycle d'horloge du K-ième cycle de comptage, cette impulsion provoquant le changement dans le compteur de la valeur $N_M + 1 - N_{k+1}$, les nombres naturels $N_k$ étant successivement fournis par les moyens mémoire (12) et $N_M$ étant la valeur maximum donnée que peut afficher le compteur (11).

12. Dispositif selon l'une quelconque des revendications 9 à 11, caractérisé en ce que les moyens mémoire (12) comprennent :

un circuit mémoire (121) contenant n + 1 variations, entières, positives ou nulles ($\Delta N_0$, ..., $\Delta N_k$, ..., $\Delta N_n$) et n + 1 erreurs ($\varepsilon_0$, ..., $\varepsilon_k$, ..., $\varepsilon_n$) aux n + 1 adresses respectives commandées par les moyens d'adressage (13) et délivrant successivement pour chaque adresse, d'ordre k variant de 0 à n, l'erreur ($\varepsilon_k$) qui forme le signal d'erreur (Se) vers la boucle de phase (100) et la variation ($\Delta N_k$) vers

un circuit de calcul (122) qui est initialisé à une valeur initiale N'o, entier positif, par les moyens de commande (14) et qui commandé par ledit signal impulsionnel prélevé ($S_R$) calcule successivement le n + 1 rang (No = N'o + $\Delta$No, Ni = No + $\Delta$N1, ..., $N_k = N_{k-1} + \Delta N_k$, ..., $N_n = N_{n-1} + \Delta N_n$) des divisions effectuées, par le diviseur programmable (11), chaque rang d'ordre k ($N_k$) étant égal à la somme de rang précédent ($N_{k-1}$) d'ordre k—1 et de la variation ($N_k$) d'ordre k avec le rang (No) d'ordre 0 égal à la somme de la valeur initiale N'o et de la variation ($\Delta$No) d'ordre 0, et ledit circuit mémoire (121) délivrant en même temps que la dernière variation ($\Delta N_n$) un signal ($S_f$) de fin de séquence vers les moyens de commande (14).

13. Dispositif selon la revendication 12, caractérisé en ce que les rangs successifs de division

(N$_0$, ..., N$_k$, ..., N$_n$) différant au plus d'une unité, le circuit mémoire (121) comprend une mémoire morte adressable (123), émettant chaque variation sous forme de deux éléments binaires (a, b) et une porte ET (127) combinant lesdits deux éléments binaires (a, b) pour former le signal de fin de séquence (S$_f$), et en ce que le circuit de calcul (122) comprend un circuit compteur/décompteur (124) initialisé à la valeur N'o par les moyens de commande (14) et alimenté par lesdits deux éléments binaires (a, b) combinés chacun avec le signal (S$_R$) prélevé en sortie du diviseur programmable (11), dans une porte ET (125, 126).

14. Dispositif selon l'une quelconque des revendications 9 à 13, caractérisé en ce que les moyens de commande (14) sont constitués par une bascule bistable R/S, alimentée sur ses entrées (S et R) respectivement par le signal extérieur de commande (S$_d$) et le signal (S$_f$) de fin de séquence, et délivre un signal d'initialisation (Si) du diviseur programmable (11), des moyens mémoire (12) et des moyens d'adressage (13).

15. Dispositif selon l'une quelconque des revendications 9 à 14, caractérisé en ce que le générateur numérique (1) comprend en outre, en aval du diviseur programmable (11), une bascule bistable (10) délivrant un signal dont les fronts montants, respectivement descendants, correspondent aux instants où la phase du signal s(t) délivré par le générateur numérique (1) est un multiple pair, respectivement impair, de π.

**Claims**

1. A device for generating a signal which is frequency modulated according to a predetermined law, comprising a digital generator delivering on the one hand, on the basis of a clock signal of period T = 1/f$_H$ and of a control signal (S$_d$) from outside, an output signal [s(t)], each halfwave of which presents a variable duration (N$_0$T, N$_1$T, ..., N$_k$T, ..., N$_n$T), which is an integer multiple of the clock period, characterized in that said generator supplies on the other hand an error signal (S$_e$) representing the errors of said output signal [s(t)] with respect to a theoretical signal (S$_t$), which is modulated according to the predetermined law, and that the device comprises in series relationship :

error correcting means (2) fed by said output signal [s(t)] and controlled by the error signal (S$_e$), said error correction means (2) including a delay circuit (20) which is controlled by said error signal (S$_e$) and applies a variable delay to said output signal [s(t)], and further including in series relationship at the output of the delay circuit (20)

an amplitude/phase detector (21), a first input of which is fed by said delayed output signal,

an amplifier (22) and

a frequency controlled oscillator circuit (23), the output of which is applied to the second input of said amplitude/phase detector (21).

2. A device according to claim 1, characterized in that the delay circuit (20) is a delay line (202) having multiple outputs which are selected by a switch circuit (201).

3. A device according to claim 1 or 2, characterized in that the delay circuit (20) has a continuous delay variation which is controlled by the error signal (S$_e$) via a digital/analog converter (200).

4. A device according to claim 3, characterized in that the delay circuit (20) comprises a comparator (203) having a variable threshold and being fed by the delayed or not delayed output signal [s(t)], filtered by a filter circuit (204).

5. A device according to claim 3, characterized in that the delay circuit (20) includes a monostable flip-flop (205) having a variable delay.

6. A device according to claim 1, characterized in that the error correcting means (2) comprise in series relationship :

an amplitude/phase detector (21) fed on a first input by the signal [s(t)] delivered by the digital generator (1),

an adder circuit (25) receiving on a positive input the output signal of the amplitude/phase detector (21) and on a negative input the error signal (S$_e$) via a digital/analog converter (24),

an oscillator circuit (23), the frequency of which is controlled by the output signal of the adder circuit (25) via an amplifier (22), the output of the oscillator circuit (23) being applied to the second input of the amplitude/phase detector (21).

7. A device according to any one of claims 1 to 6, characterized in that the oscillator circuit (23) comprises

a first oscillator (231), the frequency of which is controlled by the signal [s(t)] supplied by the digital generator (1),

a mixer (233) receiving on a first input the variable frequency signal delivered by said first oscillator (231) and on a second input a fixed frequency signal delivered by a second oscillator (232),

and a frequency divider circuit (234) receiving the output signal of said mixer (233) and delivering an output signal to the second input of the amplitude/phase detector.

8. A device according to any one of claims 1 to 7, characterized in that said oscillator circuit (23) receives an anticipation signal (S$_a$) representing the theoretical modulation law of the frequency to be generated.

9. A device according to any one of claims 1 to 8, characterized in that the digital generator (1) includes :

a programmable divider (11) producing a signal [s(t)], each period of the order k of which is an integer multiple N$_k$ > 1, k varying from zero to n, of the clock signal period T, and approaches as closely as possible the period corresponding to the theoretical signal (S$_t$),

memory means (12) supplying successively (n + 1) natural numbers (N$_0$, ..., N$_k$, ..., N$_n$) to the programmable divider (11), and said error signal (S$_e$),

addressing means (13) for controlling the memory means (12),

and control means (14) for triggering said device and for stopping it at the end of the phase of reading the content of the memory means (12) and for re-setting the programmable divider (11) and the addressing means (13), the programmable divider (11), the memory means (12) and the addressing means (13) being also controlled by a signal $(S_R)$ available at the output of said programmable divider (11).

10. A device according to claim 9, characterized in that the programmable divider (11) is a down-counter, the content of which is decremented by one unit at each clock cycle beginning with the value $N_k - 1$, the natural number $N_k$ being supplied by the memory means (12) at the beginning of each counting cycle down to the value 0 marking the end of the counting cycle of the order k and corresponding to the emission of a pulse by the down-counter, this pulse coinciding with the $n^{th}$ and last clock cycle of the $k^{th}$ counting cycle, this pulse causing the down-counter to be charged with the value $N_{k+1} - 1$, the natural numbers $N_k$ being successively supplied by the memory means (12) addressed by the addressing means (13), k being included between 0 and n.

11. A device according to claim 9, characterized in that the programmable divider (11) is a counter, the content of which is incremented by one unit at each clock cycle beginning with the value $N_{M+1} - N_k$ up to a value $N_M$ marking the end of the counting cycle of the order k and corresponding to the emission of a pulse by the counter, this pulse coinciding with the $n^{th}$ and last clock cycle of the $K^{th}$ counting cycle and causing the counter to be charged with the value $N_{M+1} - N_{k+1}$, the natural numbers $N_k$ being successively supplied by the memory means (12) and $N_M$ being the highest given value to be registered in the counter (11).

12. A device according to any one of claims 9 to 11, characterized in that the memory means (12) comprise :

a memory circuit (121) containing n + 1 variations, integers, positive or zero $(\Delta N_0, ..., \Delta N_k, ..., \Delta N_n)$ and n + 1 errors $(\varepsilon_0, ..., \varepsilon_k, ..., \varepsilon_n)$ at respective n + 1 addresses controlled by the addressing means (11) and delivering successively, for each address of the order k varying between zero and n, the error $(\varepsilon_k)$, constituting the error signal $(S_e)$ towards the phase loop (21, 22, 23) and the variation $(\Delta N_k)$ towards,

a computing circuit (122) which is reset to an initial value N'o, integer positive, by the control means (14) and which, under the control of said available pulse signal $(S_R)$, calculates successively the n + 1 rank $(No = N'o + \Delta No, Ni = No + \Delta N1, ..., N_k = N_{k-1} + \Delta N_k, ..., N_n = N_{n-1} + \Delta N_n)$ of the divisions performed by the programmable divider (11), each rank of the order k $(N_k)$ being equal to the sum of the preceding rank $(N_{k-1})$ of the order k — 1 and of the variation $(N_k)$ of the order k with the rank (No) of the order zero equal to the sum of the initial value N'o and the variation $(\Delta No)$ of the order zero, and said memory circuit (121) delivering together with the last variation $(\Delta N_n)$ a signal $(S_f)$ towards the control means (14) signifying the end of the sequence.

13. A device according to claim 12, characterized in that, the successive division ranks $(N_0, ..., N_k, ..., N_n)$ differing at most by one unity, the memory circuit (121) comprises an addressable ROM (123) transmitting each variation in the form of two binary elements (a, b), and an AND-gate (127) combining these two binary elements (a, b) in order to constitute the signal signifying the end of the sequence $(S_f)$, and that the computing circuit (122) comprises an Up/Down counter circuit (124) which is set to the value N'o by the control means (14) and which is supplied by said two binary elements (a, b) which are each combined in an AND-gate (125, 126) with the signal $(S_R)$ available at the output of the programmable divider (11).

14. A device according to any one of claims 9 to 13, characterized in that the control means (14) are constituted by a bistable flip-flop of the R/S type, the inputs (S and R) of which are respectively supplied with the control signal from outside $(S_d)$ and the signal $(S_f)$ signifying the end of the sequence, this flip-flop delivering a reset signal (Si) for resetting the programmable divider (11), the memory means (12) and the addressing means (13).

15. A device according to any one of claims 9 to 14, characterized in that the digital generator (1) further comprises downstream of the programmable divider (11) a bistable flip-flop (10) supplying a signal, the leading or sloping edges respectively corresponding to the instants at which the phase of the signal [s(t)] delivered by the digital generator (1) is an even or an odd multiple respectively of $\pi$.

**Patentansprüche**

1. Vorrichtung zur Erzeugung eines nach einem vorgegebenen Gesetz frequenzmodulierten Signals, mit einem digitalen Generator, der ausgehend von einem Taktsignal einer Periode $T = 1/f_H$ und einem von außen kommenden Steuersignal $(S_d)$ einerseits ein Ausgangssignal [s(t)] liefert, von dem jede Halbwelle eine variable Dauer $(N_0T, N_1T, ..., N_kT, ..., N_nT)$ besitzt, die ein ganzzahliges Vielfaches der Taktperiode ist, dadurch gekennzeichnet, daß der Generator andererseits ein Fehlersignal $(S_e)$ liefert, das die Fehler des Ausgangssignals [s(t)] bezüglich eines theoretischen nach dem vorgegebenen Gesetz modulierten Signals $(S_t)$ liefert, und daß die Vorrichtung in Reihe enthält

Fehlerkorrekturmittel (2), die von dem Ausgangssignal [s(t)] gespeist und vom Fehlersignal $(S_e)$ gesteuert werden, wobei die Fehlerkorrekturmittel (2) einen Verzögerungskreis (20), der unter Steuerung durch das Fehlersignal $(S_e)$ das Ausgangssignal [s(t)] um einen variablen Wert verzögert, und außerdem am Ausgang des Verzögerungskreises (20) in Reihe hintereinander enthalten

einen Amplituden/Phasendetektor (21), dessen erster Eingang das verzögerte Ausgangssignal zugeführt erhält,

einen Verstärker (22),

und einen in seiner Frequenz gesteuerten Oszillator (23), dessen Ausgang an den zweiten Eingang des Amplituden/Phasendetektors (21) angeschlossen ist.

2. Vorrichtung nach Anspruch 1, dadurch gekennzeichnet, daß der Verzögerungskreis (20) eine Verzögerungsleitung (202) ist, die zahlreiche durch einen Umschaltkreis (201) ausgewählte Ausgänge besitzt.

3. Vorrichtung nach Anspruch 1 oder 2, dadurch gekennzeichnet, daß der Verzögerungskreis (20) kontinuierlich variabel ist und vom Fehlersignal ($S_e$) über einen Digital/Analogwandler (200) gesteuert wird.

4. Vorrichtung nach Anspruch 3, dadurch gekennzeichnet, daß der Verzögerungskreis (20) einen Komparator (23) mit variabler Schwelle aufweist, der vom Ausgangssignal [s(t)] gespeist wird, das verzögert ist oder nicht und in einen Filterkreis (4) gefiltert wird.

5. Vorrichtung nach Anspruch 3, dadurch gekennzeichnet, daß der Verzögerungskreis (20) eine monostabile Kippstufe (205) mit variabler Verzögerungszeit umfaßt.

6. Vorrichtung nach Anspruch 1, dadurch gekennzeichnet, daß die Fehlerkorrekturmittel (2) in Reihe enthalten

einen Amplituden/Phasendetektor (21), dessen erster Eingang das vom digitalen Generator (1) gelieferte Signal [s(t)] zugeführt erhält,

einen Addierkreis (25), der über einen positiven Eingang das Ausgangssignal des Amplituden/Phasendetektors (21) und über einen negativen Eingang das Fehlersignal ($S_e$) über einen Digital/Analogwandler (24) zugeführt erhält,

einen Oszillatorkreis (23), der vom Ausgangssignal des Addierkreises (25) über einen Verstärker (22) frequenzgesteuert wird und dessen Ausgangssignal an den zweiten Eingang des Amplituden/Phasendetektors (21) angelegt wird.

7. Vorrichtung nach einem beliebigen der Ansprüche 1 bis 6, dadurch gekennzeichnet, daß der Oszillatorkreis (23)

einen ersten Oszillator (231), der vom Ausgangssignal [s(t)] des digitalen Generators (1) in seiner Frequenz gesteuert wird,

einen Mischer (233), der über einen ersten Eingang das vom ersten Oszillator (231) gelieferte Signal variabler Frequenz und über einen zweiten Eingang ein von einem zweiten Oszillator (232) geliefertes Festfrequenzsignal zugeführt erhält,

und einen Frequenzteilerkreis (234) enthält, der das Ausgangssignal des Mischers (232) zugeführt erhält und dessen Ausgangssignal an den zweiten Eingang des Amplituden/Phasendetektors (21) angelegt wird.

8. Vorrichtung nach einem beliebigen der Ansprüche 1 bis 7, dadurch gekennzeichnet, daß der Oszillatorkreis (23) ein Antizipationssignal ($S_a$)

zugeführt erhält, das das theoretische Modulationsgesetz der zu erzeugenden Frequenz darstellt.

9. Vorrichtung nach einem beliebigen der Ansprüche 1 bis 8, dadurch gekennzeichnet, daß der digitale Generator (1) aufweist :

eine programmierbaren Teiler (11), der ein Signal [s(t)] erzeugt, wobei jede Periode der Ordnung k dieses Signals ein ganzzahliges Vielfaches $N_k > 1$ der Periode T des Taktsignals ist und der Periode entsprechend dem theoretischen Signal ($S_t$) möglichst nahekommt, wobei k von 0 bis n variiert,

Speichermittel (12), die (n + 1) natürliche Zahlen ($N_0$, ..., $N_k$, ..., N) aufeinanderfolgend an den programmierbaren Teiler (11) sowie das Fehlersignal ($S_e$) liefern,

Adressiermittel (13), um die Speichermittel (12) zu steuern, und

Steuermittel (14), um die Vorrichtung zu starten und nach dem Auslesen des Inhalts der Speichermittel (12) anzuhalten sowie um den programmierbaren Teiler (11) und die Adressiermittel (13) neu einzustellen, wobei der programmierbare Teiler (11), die Speichermittel (12) und die Adressiermittel (13) außerdem von einem Signal ($S_R$) gesteuert werden, das am Ausgang des programmierbaren Teilers (11) abgreifbar ist.

10. Vorrichtung nach Anspruch 9, dadurch gekennzeichnet, daß der programmierbare Teiler (11) ein Rückwärtszähler ist, dessen Inhalt mit jedem Taktzyklus einen Rückschritt um eine Einheit ausgehend von einem Wert $N_k - 1$ erfährt, wobei die natürliche Zahl $N_k$ von den Speichermitteln (12) zu Beginn jedes Zählzyklus geliefert wird und der Zählvorgang bis zum Wert 0 fortschreitet, der das Ende des Zählzyklus der Ordnung k markiert und der Aussendung eines Impulses durch den Rückwärtszähler entspricht, der mit dem N-ten und letzten Taktzyklus des k-ten Zählzyklus zusammenfällt, wobei dieser Impuls das Laden des Rückwärtszählers auf den Wert $N_{k+1} - 1$ hervorruft und die natürlichen Zahlen $N_k$ nacheinander von den durch die Adressiermittel (13) adressierten Speichermitteln (12) geliefert werden, wobei k zwischen 0 und n liegt.

11. Vorrichtung nach Anspruch 9, dadurch gekennzeichnet, daß der programmierbare Teiler (11) ein Zähler ist, dessen Inhalt mit jedem Taktzyklus einen Zählschritt um eine Einheit ausgehend vom Wert $N_{M+1} - N_k$ bis zum Wert $N_M$ erfährt, der das Ende des Zählzyklus der Ordnung k markiert und der Aussendung eines Impulses durch den Zähler entspricht, wobei dieser Impuls mit dem N-ten und letzten Taktzyklus des K-ten Zählzyklus zusammenfällt und das Laden des Zählers mit dem Wert $N_{M+1} - N_{k+1}$ hervorruft und wobei die natürlichen Zahlen $N_k$ nacheinander von den Speichermitteln (12) geliefert werden und $N_M$ der gegebene Höchstwert ist, den der Zähler (11) annehmen kann.

12. Vorrichtung nach einem beliebigen der Ansprüche 9 bis 11, dadurch gekennzeichnet, daß die Speichermittel (12) enthalten

einen Speicherkreis (121), der n + 1 ganzzahlige positive Werte oder Null ($\Delta N_0$, ..., $\Delta N_k$, ..., $\Delta N_n$) und $n + 1$ Fehler ($\varepsilon_0$, ..., $\varepsilon_k$, ..., $\varepsilon_n$) an $n + 1$ entsprechenden Adressen gespeichert hält, die von Adressiermitteln (13) gesteuert werden, wobei der Speicherkreis nacheinander für jede Adresse der Ordnung k, die von 0 bis n variiert, den Fehler ($\varepsilon_k$), der das Fehlersignal ($S_e$) bildet, zur Phasenschleife (21, 22, 23) sowie die Variation ($\Delta N_k$) liefert,

einen Rechenkreis (122), der auf einen ganzzahligen positiven Anfangswert N'o durch die Steuermittel (14) eingestellt wird und der durch das abgegriffene Impulssignal ($S_R$) gesteuert nacheinander den $n + 1$ Rang (No = N'o + $\Delta$No, Ni = No + $\Delta$N1, ..., $N_k = N_{k-1} + \Delta N_k$, ..., $N_n = N_{n-1} + \Delta N_n$) der vom programmierbaren Teiler (11) durchgeführten Divisionen berechnet, wobei jeder Rang der Ordnung k ($N_k$) gleich der Summe des vorhergehenden Rangs ($N_{k-1}$) der Ordnung k — 1 und der Variation ($N_k$) der Ordnung k mit dem Rang (No) der Ordnung 0 gleich der Summe des Ursprungswerts N'o und der Variation ($\Delta$No) der Ordnung 0 ist und wobei der Speicherkreis (121) gleichzeitig mit der letzten Variation ($\Delta N_n$) ein das Ende der Sequenz anzeigendes Signal ($S_f$) an die Steuermittel (14) liefert.

13. Vorrichtung nach Anspruch 12, dadurch gekennzeichnet, daß bei einer Differenz der Teilerränge ($N_0$, ..., $N_k$, ..., $N_n$) höchstens um eine Einheit, der Speicherkreis (121) einen adressierbaren Festwertspeicher (123), der jede Variation in Form von zwei Binärelementen (a, b) ausgibt, und ein UND-Tor (127) enthält, das die beiden Binärelemente (a, b) kombiniert, um ein das Ende der Sequenz anzeigendes Signal ($S_f$) zu bilden, und daß der Rechenkreis (122) einen Vorwärts/Rückwärtszähler (124) enthält, der von den Steuermitteln (14) auf den Anfangswert N'o eingestellt wird und von den beiden Binärelementen (a, b) gespeist wird, wobei diese Binärelemente je mit dem am Ausgang des programmierbaren Teilers (11) verfügbaren Signal ($S_R$) in einem UND-Tor (125, 126) kombiniert werden.

14. Vorrichtung nach einem beliebigen der Ansprüche 9 bis 13, dadurch gekennzeichnet, daß die Steuermittel (14) von einer bistabilen Kippstufe vom R/S-Typ gebildet werden, deren Eingänge (S und R) mit dem von außen kommenden Steuersignal ($S_d$) bzw. dem das Ende der Sequenz anzeigenden Signal ($S_f$) gespeist werden und die ein Initialisierungssignal (Si) für den programmierbaren Teiler (11), für die Speichermittel (12) und die Adressiermittel (13) liefert.

15. Vorrichtung nach einem beliebigen der Ansprüche 9 bis 14, dadurch gekennzeichnet, daß der digitale Generator (1) außerdem dem programmierbaren Teiler (11) nachgeschaltet eine bistabile Kippstufe (10) aufweist, die ein Signal liefert, dessen Anstiegsflanken bzw. abfallende Flanken den Zeitpunkten entsprechen, an denen die Phase des vom digitalen Generator (1) gelieferten Signals [s(t)] ein geradzahliges Vielfaches bzw. ungeradzahliges Vielfaches von $\pi$ ist.

FIG_1

HORLOGE — 5

GÉNÉRATEUR NUMÉRIQUE — 1

$s(t)$

MOYENS DE CORRECTION D'ERREURS — 2

$S_d$

$S_e$

FIG_2

$f_H$

DIVISEUR PROGRAMMABLE RAZ — 11

$s(t)$

BASCULE — 10

$s(t)$

$S_R$

$N_k$

$S_e$

$S_d$

CIRCUIT DE COMMANDE — 14

$S_f$

$S_i$

MOYENS MÉMOIRE — 12

COMPTEUR RAZ D'ADRESSES — 13

# FIG_3-A

$N_R$

$S_i$ → CIRCUIT DE CALCUL ← $S_R$

122

$S_e$

121

$S_f$ ← MÉMOIRE

12

# FIG_3-B

122

124

$S_l$ → COMPTEUR/DÉCOMPTEUR

125    126

$S_f$ ←    ← $S_R$

127

a    b    $S_e$

121    MÉMOIRE

12    123

# FIG_5-A

2

$\delta(t)$ → CIRCUIT DE RETARD    20

$S_e$

# FIG_5-B

2

$\delta(t)$ → CIRCUIT DE RETARD    20    DAP    22    CIRCUIT OSCILLATEUR COMMANDE EN FRÉQUENCE    23

21

$S_e$

FIG_6-A

20

∂(t)

202

201

CIRCUIT DE
COMMUTATION

Se

→21

FIG_6-B

∂(t)

204

203

21

CONVERTISSEUR N/A

200

Se

20

FIG_6-C

∂(t)

BASCULE
MONOSTABLE

205

→21

20

200

CONVERTISSEUR
N/A

## FIG_4

## FIG_7

# FIG_8

OSCILLATEUR COMMANDE _231_

$f_S(t)$

OSCILLATEUR A FRÉQUENCE FIXE _232_

DIVISEUR DE FRÉQUENCE _234_

$S_a$

_233_

_23_